# EUROPEAN PATENT APPLICATION

(11) **EP 2 006 915 A2**
(43) Date of publication of application: **24.12.2008**
(21) Application number: 07739500.2
(22) Date of filing: 23.03.2007
(51) Int. Cl.: H01L 29/786, H01L 21/336, H01L 51/05, H01L 51/40

(54) **ORGANIC THIN FILM TRANSISTOR DEVICE AND METHOD FOR MANUFACTURING SAME**

(30) Priority: 29.03.2006 JP 2006090463
(71) Applicant: Pioneer Corporation, Tokyo 153-8654 (JP)
(72) Inventor: CHUMAN, Takashic/o C.R.D.L., Pioneer Corporation,, Saitama 350-2288 (JP)
(74) Representative: Manitz, Finsterwald & Partner GbR
(86) International application number: PCT/JP2007/056059
(87) International publication number: WO 2007/116660

(57) **Abstract**

An organic TFT device in which a plurality of organic TFTs can be formed in a narrow region and a manufacturing method therefor are proposed. The organic TFT device comprises a substrate, and a plurality of organic TFTs disposed in a transistor region on the substrate. The organic TFT device further comprises: a bank enclosing the transistor region and having a single opening; and a single organic semiconductor layer demarcated by the bank and forming a channel for the organic TFTs.

## Description

### TECHNICAL FIELD

The present invention relates to an organic thin film transistor device comprising a plurality of organic thin film transistors, and a manufacturing method therefor.

### BACKGROUND ART

An active matrix drive display is mainstream for so-called flat panel displays (FPDs) such as organic electroluminescent display devices (hereinafter, referred to as organic EL display devices) and electrophoretic display devices. A drive unit constructed of one thin film transistor (hereinafter, referred to as a TFT) for each pixel is provided in such displays. A display using an active matrix drive makes it possible to ensure uniformity in the screen luminance, the screen rewrite rate, and the like.

In this case, a TFT is ordinarily constructed by sequentially forming a gate electrode made of a metal thin film formed on a glass substrate, a gate insulating film for covering the gate electrode, a pair of separated and opposing source/drain electrodes on the gate insulating film, and a semiconductor layer as a channel between the source/drain electrodes. The semiconductor layer comprises an inorganic material such as a-Si (amorphous silicon) or p-Si (polysilicon).

To manufacture an FPD using TFTs with such a construction, a photolithography process with high precision is ordinarily required in addition to a thin film formation process requiring CVD (chemical vapor deposition), sputtering, or other such vacuum system equipment and a high temperature treatment process. Consequently, the burden of the equipment and running costs is extremely high.

Research and development is therefore underway into organic thin film transistors (hereinafter, referred to as organic TFTs) using a semiconductor layer comprising an organic compound. An example is disclosed in Japanese Patent Kokai No. 2002-343578 (Patent Document 1). As a method for forming an organic semiconductor layer when producing an organic TFT, vacuum deposition is generally used if the organic compound of the semiconductor layer is a low-molecular material, and printing is generally used if it is a high-molecule material. However, attempts are being made to manufacture organic TFTs using a printing process in order to maximally utilize the fact that a resin substrate can be used because of the advantages in using an organic material in the semiconductor layer of a transistor, that is, (1) that a vacuum state does not need to be formed when manufacturing a semiconductor layer, and (2) that the production of the semiconductor layer can be carried out in a low-temperature process. One such means for such a manufacturing method is injection.

Injection is a process wherein a thin film is formed with a desired shape by jetting liquid droplets comprising an organic material composing the organic semiconductor layer from a narrow nozzle toward the film formation body while controlling with electrical signals. A water repellent bank having an opening corresponding to the desired form, that is, the form of the organic TFT semiconductor layer is provided beforehand on the film formation body, and the liquid drops jetted toward the opening rebound off the bank and are disposed inside the opening.
Patent Document 1: Japanese Patent Kokai No. 2002-343578

### DISCLOSURE OF THE INVENTION

### PROBLEMS TO BE SOLVED BY THE INVENTION

When an FPD is driven by an active matrix, a plurality of organic TFTs with a construction such as that described above is required for each pixel. In the case of an organic electroluminescent element (hereinafter, referred to as an organic EL element) composing an organic EL display device, for example, a minimum of two switching and driving organic TFTs is required for each organic EL element for active matrix driving of the organic EL element. Consequently, a bank having an opening for each organic TFT must be formed when using the inkjet process.

The smaller the pixel size becomes in the display device, the smaller the size and intervals of the organic TFTs become. It is therefore difficult to produce an organic semiconductor layer for each organic TFT. In other words, when the size and intervals of the organic TFTs become small (on the order of several µm) in comparison to the impact precision (up to around 10 µm) of the liquid drops jetted from the inkjet nozzle, film formation becomes extremely difficult with the inkjet process.

### MEANS FOR SOLVING THE PROBLEM

An object of the present invention is to provide means for solving problems exemplified by that described above.

The organic TFT device recited in claim 1 has a substrate and a plurality of organic TFTs disposed in a transistor region on the substrate, wherein the organic TFT device comprises a bank enclosing the transistor region and having a single opening, and a single organic semiconductor layer demarcated by the bank and forming a channel of the organic TFTs.

The manufacturing method for an organic TFT device according to another aspect of the present invention is for an organic TFT device having a substrate and a plurality of organic TFTs arranged in a transistor region on the substrate, the method comprising the steps of: forming a plurality of gate electrodes in the transistor region; forming a gate insulating film on each gate electrode; forming a source electrode and a drain electrode mutually separated and opposing, on the gate insulating film; forming a bank having a single opening enclosing the transistor region; and forming a single organic semiconductor layer as a channel of the organic TFTs in use of an inkjet process in the region enclosed by the bank.

### BRIEF DESCRIPTION OF THE DRAWINGS

Fig. 1 is a partial magnified plan view of the organic EL display device having the organic TFT device according to the present invention;
Fig. 2 is a plan view showing a subpixel of the organic EL display device having the organic TFT device according to the present invention;
Fig. 3 is a cross-section view of the line A-A of Fig. 2;
Fig. 4 is a circuit view showing the structure of the subpixel of the organic EL display device having the organic TFT device according to the present invention;
Fig. 5 is a timing chart showing the operation of the subpixel of the organic EL display device having the organic TFT device according to the present invention;
Fig. 6 is a plan view for explaining the manufacturing process of the subpixel of the organic EL display device having the organic TFT device according to the present invention;
Fig. 7 is a plan view for explaining the manufacturing process of the subpixel of the organic EL display device having the organic TFT device according to the present invention;
Fig. 8 is a plan view for explaining the manufacturing process of the subpixel of the organic EL display device having the organic TFT device according to the present invention;
Fig. 9 is a plan view for explaining the manufacturing process of the subpixel of the organic EL display device having the organic TFT device according to the present invention;
Fig. 10 is a plan view for explaining the manufacturing process of the subpixel of the organic EL display device having the organic TFT device according to the present invention;
Fig. 11 is a plan view for explaining the manufacturing process of the subpixel of the organic EL display device having the organic TFT device according to the present invention;
Fig. 12 is a plan view for explaining the manufacturing process of the subpixel of the organic EL display device having the organic TFT device according to the present invention;
Fig. 13 is a plan view for explaining the manufacturing process of the subpixel of the organic EL display device having the organic TFT device according to the present invention; and
Fig. 14 is a plan view showing an alternate example of the subpixel of the organic EL display device having the organic TFT device according to the present invention.

### EXPLANATION OF REFERENCE SIGNS

- 1: organic EL display device
- 2: substrate
- 3: pixel part
- 3R, 3G, 3B: subpixels
- 4: organic EL element
- 7: capacitor
- 9: transistor region
- 10: first organic TFT
- 11: second organic TFT
- 12: third organic TFT
- 13: fourth organic TFT
- 14: organic TFT device
- 15: opening
- 16: bank
- 17: organic semiconductor layer
- 18: gate electrode
- 19: gate insulating film
- 20: source electrode
- 21: drain electrode
- 29: partition

### MODE FOR CARRYING OUT THE INVENTION

An organic TFT device for driving organic EL element with an active matrix is described below in detail with reference to the attached drawings as an example of the organic TFT device according to the present invention.

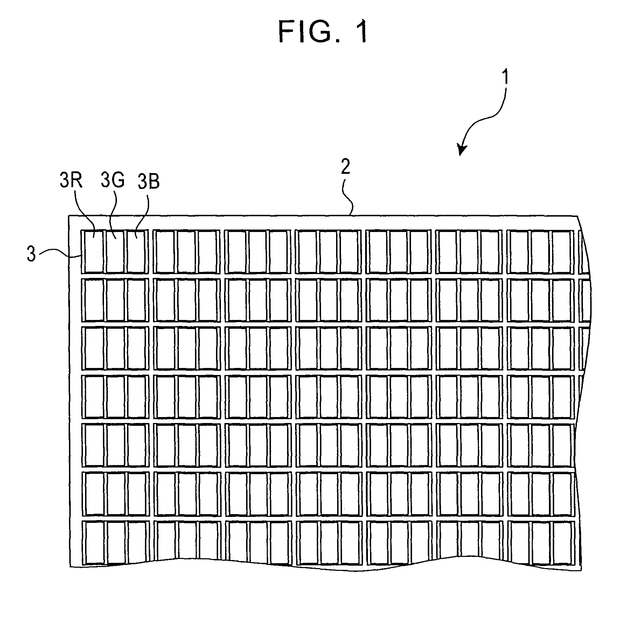

As shown in Fig. 1, an organic EL display device 1 using an active matrix drive and provided with a plurality of TFTs comprises a substrate 2, and a plurality of pixel parts 3 arranged in a matrix thereon. The pixel part 3 comprises three subpixels 3R, 3G, and 3B for emitting the three primary colors, red (R), green (G), and blue (B), and the subpixels 3R, 3G, and 3B are aligned in the pixel part 3.

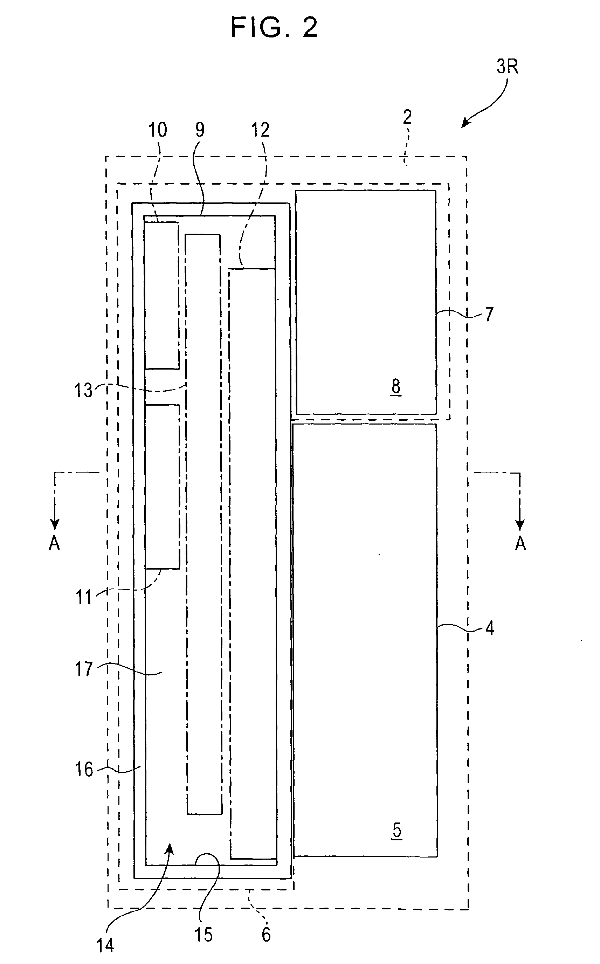

The subpixels 3R, 3G, and 3B each comprise an organic EL element (not illustrated in Fig. 1). The subpixel 3R comprising an organic EL element 4 for emitting red (R) light as shown in Fig. 2 is used for explanation as an example of a subpixel. Illustration of a wire connected to the structural element composing the subpixel 3R is omitted in Fig. 2 to simplify the explanation.

The organic EL element 4 has a first display electrode (not illustrated in Fig. 2) and a second display electrode 5 as an anode and a cathode as well as an organic functional layer (not illustrated in Fig. 2) held between the first and second display electrodes, and is sequentially constructed by arranging the first display electrode, the organic functional layer, and the second display electrode 5 starting from the substrate 2. The organic functional layer comprises a light-emitting layer (not illustrated) capable of emitting light through the recombination of a hole and an electron. A hole injection layer, a hole transport layer, an electron transport layer and/or an electron injection layer may be arbitrarily provided in the organic functional layer to enhance the injectability or transportability of holes or electrons in the light-emitting layer.

A drive unit 6 for driving the organic EL element 4 is provided near the organic EL element 4 and comprises a capacitor 7. The capacitor 7 comprises a first capacitor electrode (not illustrated in Fig. 2), a second capacitor electrode 8, and a capacitor insulating film (not illustrated in Fig. 2) held between the first and the second capacitor electrodes.

A transistor region 9 is provided near the organic EL element 4 and the capacitor 7 in the subpixel 3R. The transistor region 9 here refers to a region on the substrate in which a plurality of organic TFTs 10 to 13 are disposed, and the four organic TFTs 10 to 13 are formed in the transistor region 9 as shown in Fig. 2. Although not illustrated, a plurality of transistor regions may be provided on the substrate as well. The four organic TFTs 10 to 13 are arranged, aligned in a plane in the transistor region 9, and the plurality of organic TFTs 10 to 13 form an organic TFT device 14. The four organic TFTs 10 to 13 and the capacitor 7 together constitute the drive unit 6 of the organic EL element 4. Each of the four organic TFTs 10 to 13 also function as a switching transistor or a driving transistor, described in detail below.

A bank 16 having a single opening 15 enclosing the transistor region 9 is provided thereat. In other words, the plurality of organic TFTs 10 to 13 are surrounded by the bank 16. The bank 16 demarcates a single organic semiconductor layer 17 for forming a channel of the organic TFTs 10 to 13, and the organic semiconductor layer 17 is shared by the plurality of organic TFTs 10 to 13. The form of the opening 15 of the bank corresponds to the layout of the plurality of organic TFTs 10 to 13.

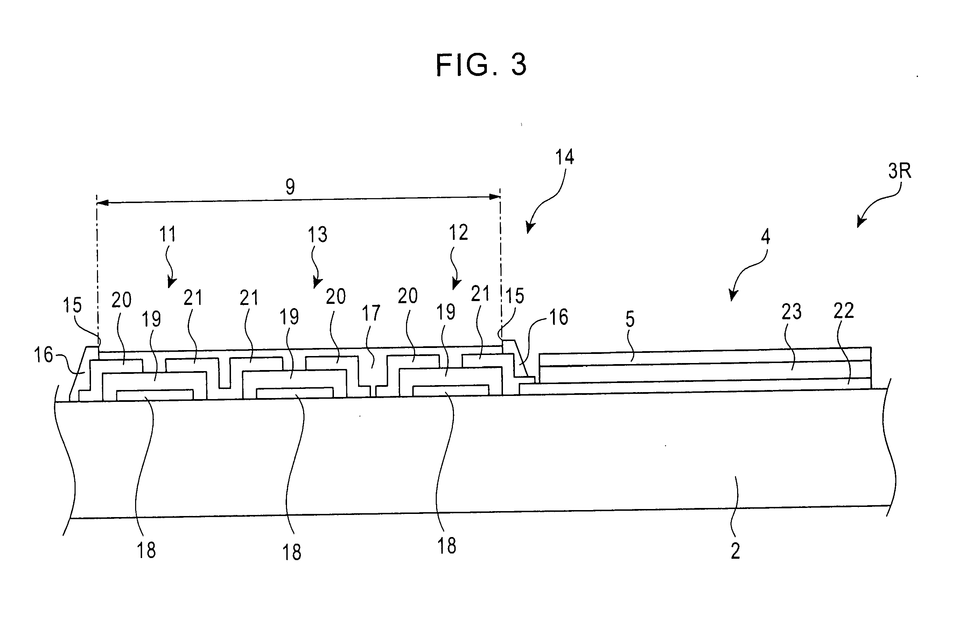

A gate electrode 18 is disposed on the substrate 2 in the transistor region 9 as shown in Fig. 3. The substrate 2 comprises glass, and the gate electrode 18 is constructed from a conductive thin film comprising tantalum (Ta). The substrate 2 is not limited to a glass substrate, but may be a laminate substrate of a resin substrate and plastic as well. In the present specification, the substrate refers to a member for supporting the organic EL element and the organic TFTs, and includes substrates for which a structure such as an alkali barrier film and/or a gas barrier film is formed in the surface of a substrate material such as glass and/or resin. The gate electrode 18 is connected to a charge control line and a scan line (neither of which are illustrated in Fig. 3). A gate insulating film 19 is provided on the gate electrode 18. The gate insulating film 19 comprises tantalum oxide (Ta₂O₅) and may be formed by anodization of the tantalum of the gate electrode 18.

A source electrode 20 and a drain electrode 21 are provided on the gate insulating film 19, and the source electrode 20 and the drain electrode 21 are separated and oppose each other on the gate insulating layer 19. The source electrode 20 and the drain electrode 21 comprise a metal thin film Cr/Au comprising gold (Au) with an attachment layer of chrome (Cr). The source electrode 20 and the drain electrode 21 are connected to a data line and a power source line (neither of which are illustrated in Fig. 3).

In the transistor region 9 comprising the gate electrode 18, the gate insulating film 19, the source electrode 20, and the drain electrode 21 as described above, the bank 16 having the single opening 15 enclosing said region is formed. The bank 16 is disposed on a portion of the source electrode 20 and the drain electrode 21. The bank 16 comprises an insulating fluorine photosensitive resin.

The single organic semiconductor layer 17 demarcated by the bank 16 is provided on the source electrode 20 and the drain electrode 21, and the organic semiconductor layer 17 is common to the plurality of organic TFTs 10 to 13 in the transistor region 9. The organic semiconductor layer 17 is disposed in a gap between the source electrode 20 and the drain electrode 21 in the gate insulating film 19. The organic semiconductor layer 17 is in contact with the gate insulating film 19 and opposes the gate electrode 20 via the gate insulating film 19 in the gap region. The organic semiconductor layer 17 in the gap region may be the channel of the organic TFTs 10 to 13. From the above, the bank 16 demarcates the transistor region 9. The organic semiconductor layer 17 here comprises an organic material showing semiconductor characteristics such as poly(3-hexylthiophene) (P3HT), for example. The organic semiconductor layer 17 may comprise a plurality of semiconductor characteristic materials or a laminate as well.

The organic EL element 4 disposed near the transistor region 9 is sequentially constructed from a first display electrode 22, an organic functional layer 23, and the second display electrode 5 starting from the substrate 2. The first display electrode 22 is connected to the drain electrode 21 of the organic TFT 12 disposed near the organic EL element.

Although not illustrated, a pixel part of the organic EL display device constructed as described above is sealed by a dish-shaped sealing cap or sealing film, made such that the organic EL element is not in contact with moisture or oxygen in the atmosphere.

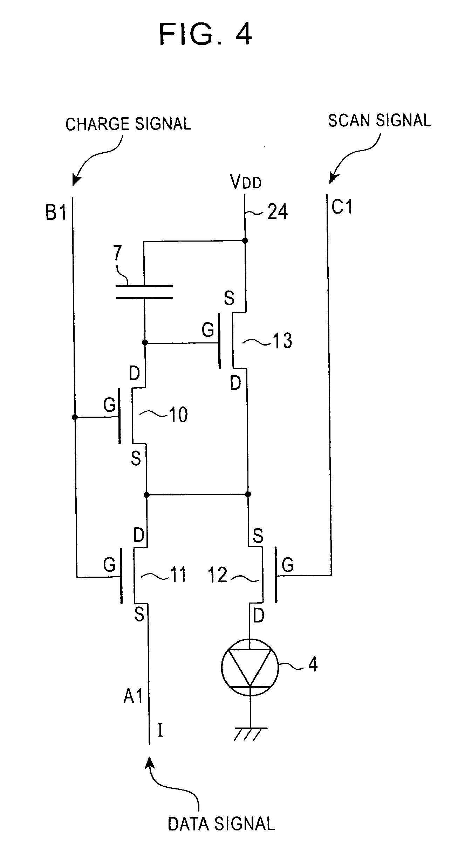

The subpixel constructed as described above can be expressed with a circuit diagram as shown in Fig. 4. The organic EL element 4, the first through fourth organic TFTs 10 to 13, and the capacitor 7 are provided inside the subpixel. The capacitor 7 maintains a charge in response to a data signal supplied via a data line A1, and regulates gradation of the emitted light of the organic EL element 4. In other words, the capacitor 7 maintains a voltage in response to a current flowing in the data line A1. Since the organic EL element 4 is a current driven type light-emitting element similar to a photodiode, the symbol for a diode is depicted here.

A source S of the first organic TFT 10 is connected to each of drains D of the second and fourth organic TFTs 11 and 13 as well as a source S of the third organic TFT 12. The drain D of the first organic TFT 10 is connected to a gate G of the fourth organic TFT 13. The capacitor 7 is connected between a source S and a gate G of the fourth organic TFT 13. The source S of the fourth organic TFT 13 is connected to a power source line 24, and a drive voltage V_{DD} is supplied to the power source 24. The first display electrode 22 (refer to Fig. 3) as the anode of the organic EL element 4 is connected to a drain D of the third organic TFT 12, and the second display electrode 5 as the cathode of the organic EL element 4 is grounded.

Gates G of the first organic TFT 10 and the second organic TFT 11 are commonly connected to a charge control line B1 for controlling a charge to the capacitor 7, and receive input of a charge signal for data writing. Also, a gate G of the third organic TFT 12 is connected to a scan line C1, and receives input of a scan signal for light emission interval setting.

The first organic TFT 10 and the second organic TFT 11 are switching transistors used when accumulating a charge in the capacitor 7. The third organic TFT 12 is a switching transistor held in an on state during a light emission interval of the organic EL element 4. The fourth organic TFT 13 is a drive transistor for controlling the current value flowing in the organic EL element 4. The current value of the fourth organic TFT 13 is controlled by the amount of charge maintained in the capacitor.

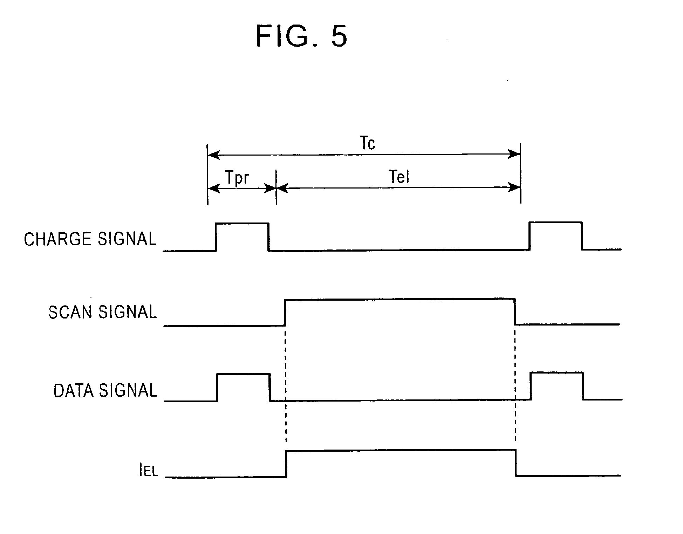

Fig. 5 is a timing chart showing the operation of the subpixel. A charge signal inputted via the charge control line B1, a scan signal inputted via the scan line C1, a data signal (a data current value I) inputted via the data line A1, and a current value I_{EL} flowing in the organic EL element are shown therein.

Tc is a frame interval, during which a selection spanning all of the scan lines completes. Tpr is a program interval determined by the charge signal for data writing inputted via the charge control line B1, during which the light emission gradation of the organic EL element is set inside the subpixel. Tel is a light emission interval determined by the scan signal for light emission interval setting inputted via the scan line C1, during which the organic EL element emits light.

During the program interval Tpr, an H level charge signal is outputted onto the charge control line B1 from a charge control line drive circuit (not illustrated) while a data signal corresponding to the light emission gradation is outputted onto the data line A1 from a data line drive circuit (not illustrated). Then the first and second organic TFTs 10 and 11 are set to an on state. At this time, the data line drive circuit (not illustrated) functions as a variable constant current source for flowing a data current value I in response to the light emission gradation. A charge corresponding to the data current value I is maintained in the capacitor 7, and the program interval Tpr ends. The voltage stored in the capacitor 7 is consequently applied between the source and drain of the fourth organic TFT 13.

When the program interval Tpr ends, the charge signal is set to an L level, and the first organic TFT 10 and the second organic TFT 11 are set to an off state. The data line drive circuit (not illustrated) also halts the supply of the data signal (current value I) for its pixel circuit.

During the subsequent light emission interval Tel, the scan signal at the H level is outputted from the scan line drive circuit (not illustrated) to the scan line C1, setting the third organic TFT 12 to an on state while the charge signal is maintained at the L level, and the first and second organic TFTs 10 and 11 are kept in an on state.

A charge corresponding to the data signal (data current value I) is maintained beforehand in the capacitor 7. A current nearly the same as the data current value I therefore flows in the fourth organic TFT 13, and that current flows in the organic EL element 4 via the third organic TFT 12. As a result, the organic EL element 4 emits light at a gradation corresponding to the data signal (data current value I) during the light emission interval Tel.

The manufacturing method is next described for the organic EL display device having an organic TFT device constructed as described above. Although the description is for a subpixel whose size is 180 µm × 60 µm, wherein the opening ratio in the organic EL element is 30%, and there are four organic TFTs, the size is not limited thereto.

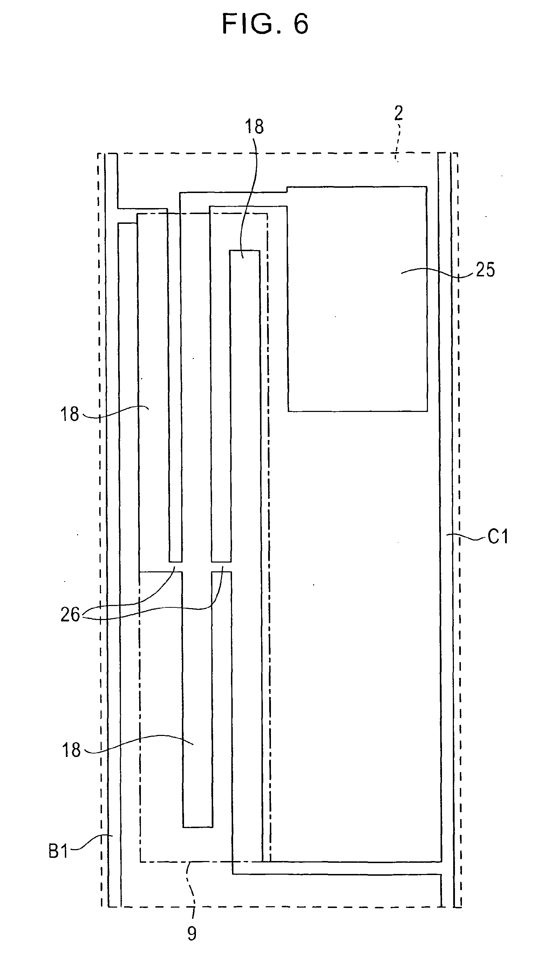

After forming a tantalum (Ta) thin film on a glass substrate comprising nonalkaline glass, reactive ion etching (RIE) is used to produce a Ta thin film pattern as shown in Fig. 6. The Ta thin film pattern comprises the gate electrodes 18, the charge control line B1, the scan line C1, and a first capacitor electrode 25. The Ta thin film pattern comprises a bridge portion 26 for electrically connecting the gate electrodes 18. The gate electrodes 18 are provided inside the transistor region 9 (indicated in Fig 6 as well as Figs. 7 to 10 with an alternately long and short dashed line).

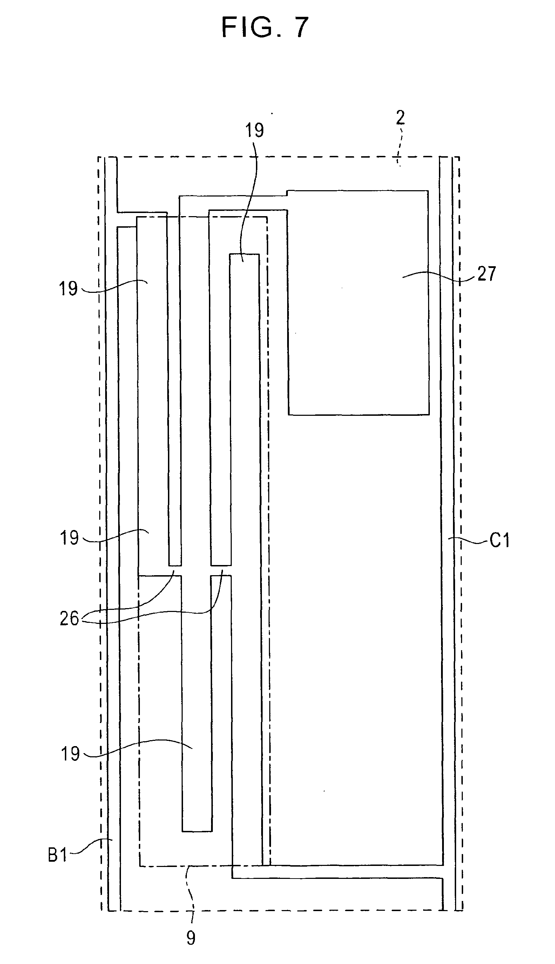

Anodization is carried out on the Ta thin film pattern, and a tantalum oxide (Ta₂O₅) film is produced on the surface of the Ta thin film. As shown in Fig. 7, the Ta₂O₅ film becomes the gate insulating film 19 on the gate electrodes 18 and a capacitor insulating film 27 on the first capacitor electrode 25. As a result of the Ta thin film comprising the bridge portion 26, the anodization of the Ta thin film can be implemented in a single step. The Ta thin film thickness is 100 nm, and the Ta₂O₅ film thickness is 150 nm.

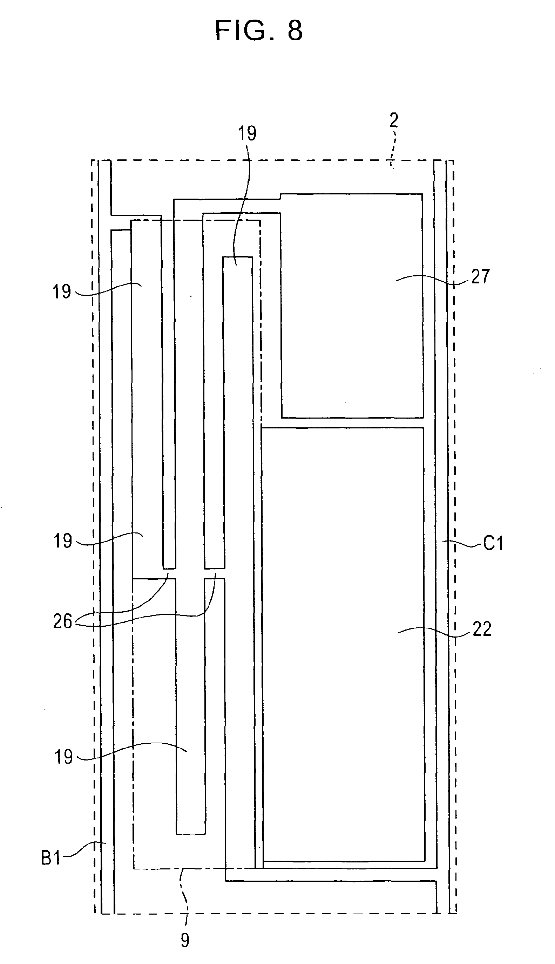

As shown in Fig. 8, after an indium zinc oxide (IZO) film is produced on the substrate, a lift-off process is used to form an IZO pattern as the first display electrode 22 of the organic EL element. The size of the first display electrode 22 is 30 µm × 110 µm, and the thickness is 110 nm.

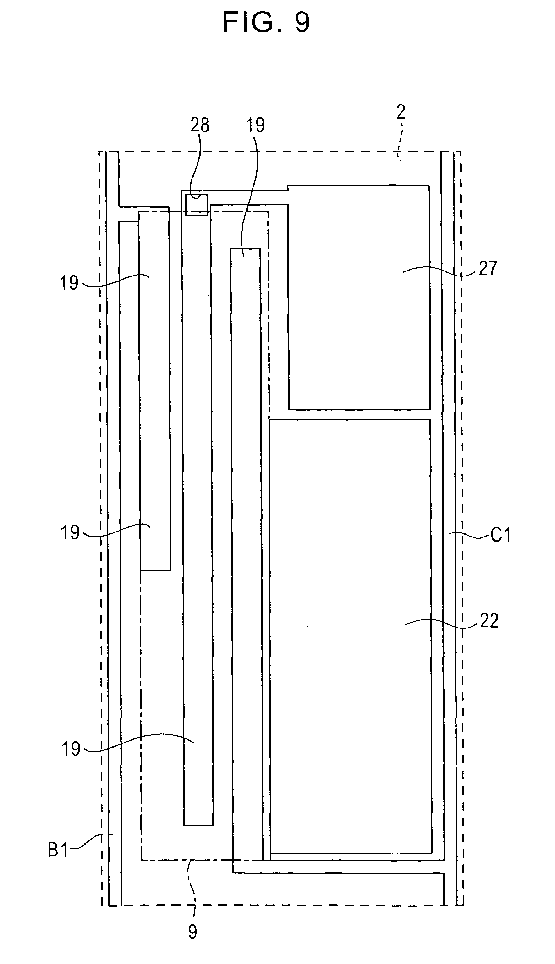

Reactive ion etching is used to remove the bridge portion 26 of the Ta thin film, electrically disconnecting the gate electrodes connected by the bridge portion 26. Also, a through hole 28 is provided in the Ta₂O₅ think film between the first capacitor electrode 25 and the gate electrode 18 as shown in Fig. 9.

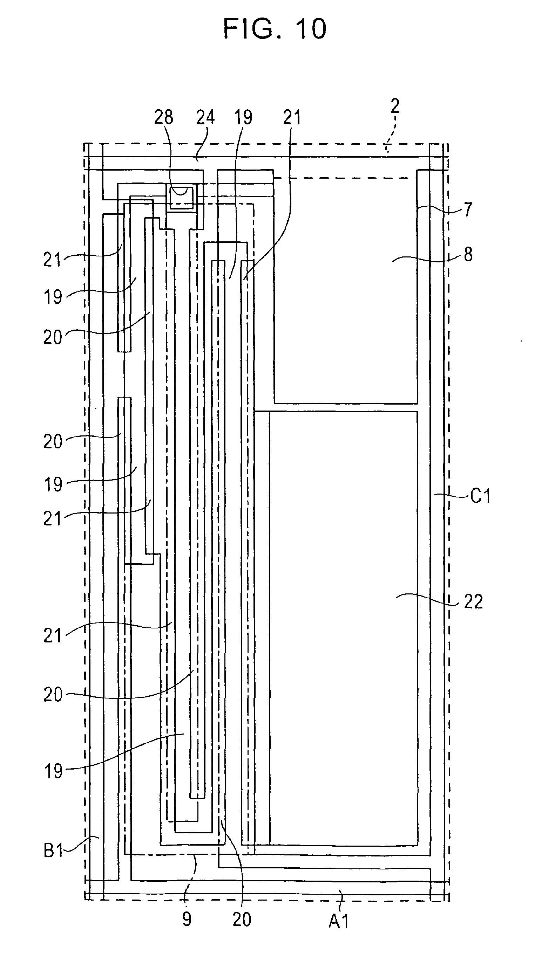

Next, gold (Au) using chrome (Cr) as the attachment layer is formed by magnetron sputtering, and a lift-off process is used to form a Cr/Au metal film with a pattern as shown in Fig. 10. The Cr/Au metal film composes the source electrodes 20, the drain electrodes 21, the data line A1, and the power source line 24. The drain electrode 21 of the third organic TFT 12 provided near the first display electrode 22 is connected to the first display electrode 22. The thickness of the Cr film is 5 nm, and that of the Au film is 100 nm.

The source electrodes 20 and the drain electrodes 21 are formed such that the channel length of the organic TFTs ultimately produced is 2 µm. Of the four organic TFTs, two are produced with a channel width of 40 µm, and two with a channel width of 150 µm.

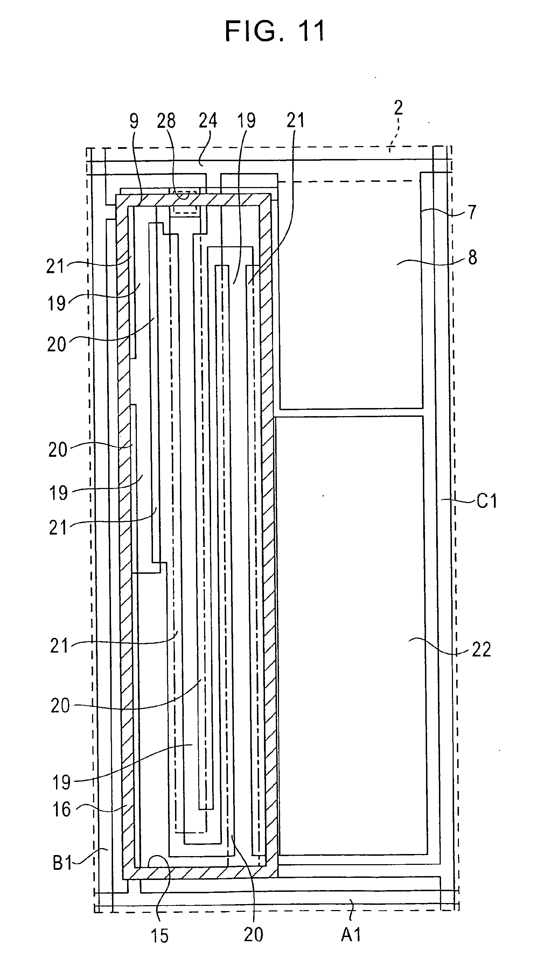

The bank 16 enclosing the transistor region 9 and having a single opening 15 is formed in the subpixel as shown in Fig. 11. The bank 16 is formed using a fluorine photosensitive resin, and the pattern thereof is formed using a photomask. The size of the opening 15 of the bank 16 is 20 µm × 170 µm, and the height of the bank 16 is 3 µm.

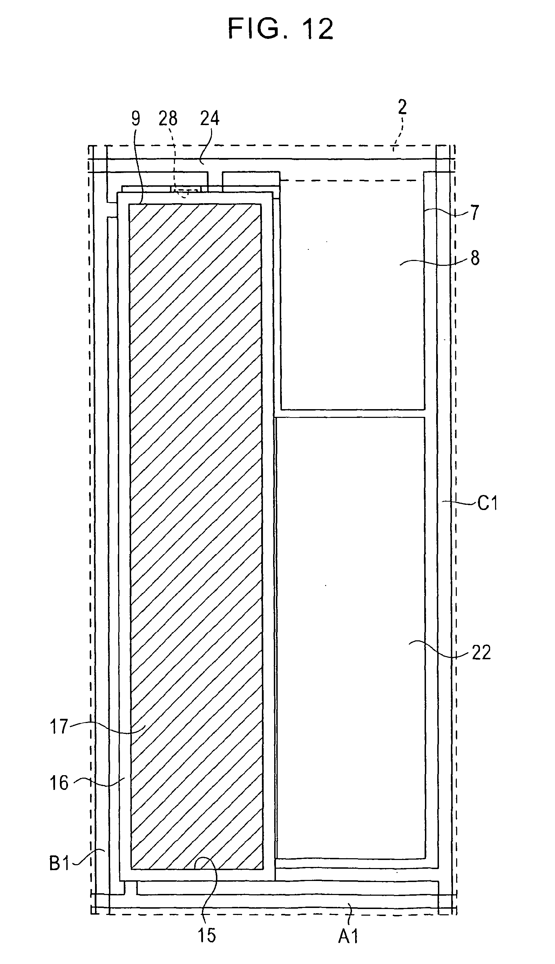

After the bank 16 is produced, an inkjet process is used to produce a single organic semiconductor layer 17 in the region enclosed by the bank 16 as shown in Fig. 12. The organic semiconductor layer 17 comprises P3HT, an organic material having semiconductor characteristics. In the inkjet process, liquid drops discharged from an inkjet nozzle (not illustrated) rebound off the bank 16 so as to be disposed inside the opening 15, and the organic semiconductor layer 17 formed by the liquid drops is formed inside the region enclosed by the bank 16. The single organic semiconductor layer 17 forms channels for the plurality of organic TFTs.

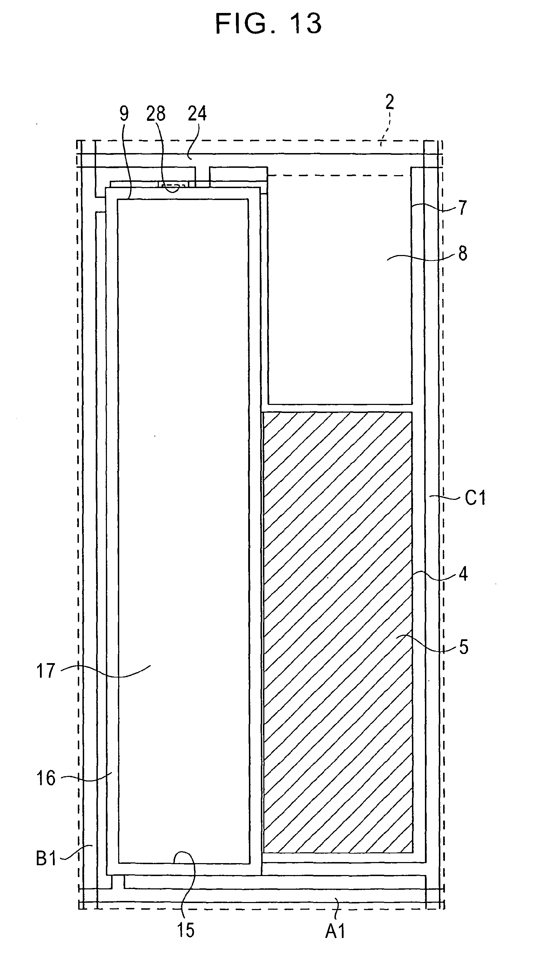

After the organic semiconductor layer 17 is produced, vacuum deposition using a shadow mask (not illustrated) is used to sequentially produce the organic functional layer 23 (refer to Fig. 3) comprising the light emitting layer (not illustrated) and the second display electrode 5 on the first display electrode 22, and the organic EL element 4 is formed as shown in Fig. 13. The organic functional layer 23 comprises a low molecular material. At the end, sealing is carried out using a dish-shaped sealing cap, completing the organic EL display device.

When the organic TFTs were driven in the organic EL display device comprising the organic TFT device as described above, light emission of the organic EL element was confirmed.

From the fact that the size of the opening of the bank is large due to forming the bank with a single opening for a plurality of organic TFTs, an organic semiconductor layer can be produced using an inkjet process even if the size of the organic TFTs and the interval therebetween are small. That is, a plurality of organic TFTs smaller (in channel width) than the impact precision of the inkjet liquid drops can be produced in a narrow region. Also, from the fact that a bank is not produced for each organic TFT, the production process of the organic TFT device can be simplified, resulting in an improved yield.

In the embodiment described above, Ta was used as the gate electrode, and Cr/Au as the source electrode and drain electrode, but those materials are not particularly limited as long as there is adequate conductivity. Specifically, a simple metal such as Pt, Au, W, Ru, Ir, Al, Sc, Ti, V, Mn, Fe, Co, Ni, Zn, Ga, Y, Zr, Nb, Mo, Tc, Rh, Pd, Ag, Cd, Ln, Sn, Ta, Re, Os, Tl, Pb, La, Ce, Pr, Nd, Pm, Sm, Eu, Gd, Tb, Dy, Ho, Er, Tm, Yb, Lu, or the like or a laminate or compound thereof may be used. Also, an organic conductive metal containing a conjugated polymer compound such as a metal oxide such as ITO or IZO, a polyaniline, a polythiophene, or a polypyrrole may be used.

Furthermore, while Ta₂O₅ produced by anodizing Ta as the gate electrode and as the gate insulating film is used in the embodiment described above, any anodizable metal is fine as the gate electrode material, and Al, Mg, Ti, Nb, Zr, and other single metals or a compound thereof may be anodized for the gate insulating film.

Furthermore, either an inorganic or organic insulating material may be used as the gate insulating film without using anodization. For example, metal oxides such as LiOₓ, LiNₓ, NaOₓ, KOₓ, RbOₓ, CsOₓ, BeO_{X}, MgOₓ, MgNₓ, CaOₓ, CaNₓ, SrOₓ, BaOₓ, ScOₓ, YOₓ, YNₓ, LaOₓ, LaNₓ, CeOₓ, PrOₓ, NdOₓ, SmOₓ, EuOₓ, GdOₓ, TbOₓ, DyOₓ, HoOₓ, ErOₓ, TmOₓ, YbOₓ, LuOₓ, TiOₓ, TiNₓ, ZrOₓ, ZrNₓ, HfOₓ, HfNₓ, ThOₓ, VOₓ, VNₓ, NbOₓ, TaOₓ, TaNₓ, CrOₓ, CrNₓ, MoOₓ, MoNₓ, WOₓ, WNₓ, MnOₓ, ReOₓ, FeOₓ, FeNₓ, RuOₓ, OsOₓ, CoOₓ, RhOₓ, IrOₓ, NiOₓ, PdOₓ, PtOₓ, CuOₓ, CuNₓ, AgOₓ, AuOₓ, ZnOₓ, CdOₓ, HgOₓ, BPₓ, BNₓ, AlOₓ, AlNₓ, GaOₓ, GaNₓ, InOₓ, TiOₓ, TiNₓ, SiNₓ, GeOₓ, SnOₓ, PbOₓ, POₓ, PNₓ, AsOₓ, SbOₓ, SeOₓ, and TeOₓ; metal compounds such as LiAlO₂, Li₂SiO₃, Li₂TiO₃, Na₂Al₂₂O₃₄, NaFeO₂, Na₄SiO₄, K₂SiO₃, K₂TiO₃, K₂WO₄, Rb₂CrO₄, Cs₂CrO₄, MgAl₂O₄, MgFe₂O₄, MgTiO₃, CaTiO₃, CaWO₄, CaZrO₃, SrFe₁₂O₁₉, SrTiO₃, SrZrO₃, BaAl₂O₄, BaFe₁₂O₁₉, BaTiO₃, Y₃Al₅O₁₂, Y₃Fe₅O₁₂, LaFeO₃, La₃Fe₅O₁₂, La₂Ti₂O₇, CeSnO₄, CeTiO₄, SM₃Fe₅O₁₂, EuFeO₃, Eu₃Fe₅O₁₂, GdFeO₃, Gd₃Fe₅O₁₂, DyFeO₃, DY₃Fe₅O₁₂, HoFeO₃, HO₃Fe₅O₁₂, ErFeO₃, Er₃Fe₅O₁₂, Tm₃Fe₅O₁₂, LuFeO₃, Lu₃Fe₅O₁₂, NiTiO_{3,} Al₂TiO₃, FeTiO₃, BaZrO₃, LiZrO₃, MgZrO₃, HfTiO₄, NH₄VO₃, AgVO₃, LiVO₃, BaNb₂O₆, NaNbO₃, SrNb₂O₆, KTaO₃, NaTaO₃, SrTa₂O₆, CuCr₂O₄, Ag₂CrO₄, BaCrO₄, K₂MoO₄, Na₂MoO₄, NiMoO₄, BaWO₄, Na₂WO₄, SrWO₄, MnCr₂O₄, MnFe₂O₄, MnTiO₃, MnWO₄, CoFe₂O₄, ZnFe₂O₄, FeWO₄, CoMoO₄, CuTiO₃, CuWO₄, Ag₂MoO₄, Ag₂WO₄, ZnAl₂O₄, ZnMoO₄, ZnWO₄, CdSnO₃, CdTiO₃, CdMoO₄, CdWO₄, NaAlO₂, MgAl₂O₄, SrAl₂O₄, Gd₃Ga₅O₁₂, InFeO₃, MgIn₂O₄, Al₂TiO₅, FeTiO₃, MgTiO₃, Na₂SiO₃₁ CaSiO₃, ZrSiO₄, K₂GeO₃, L'₂GeO₃, Na₂GeO₃, Bi₂Sn₃O₉, MgSnO₃, SrSnO₃, PbSiO₃, PbMoO₄, PbTiO₃, SnO₂-Sb₂O₃, CuSeO₄, Na₂SeO₃, ZnSeO₃, K₂TeO₃, K₂TeO₄, Na₂TeO₃, and Na₂TeO₄; sulfides such as FeS, Al₂S₃, MgS, and ZnS; fluorides such as LiF, MgF₂, and SmF₃; chlorides such as HgCl, FeCl₂, and CrCl₃; bromides such as AgBr, CuBr, and MnBr₂; iodides such as PbI₂, CuI, and FeI₂; and metal oxide nitrides such as SiAlON are effective as well. Polymer materials such as polyimides, polyamides, polyesters, polyacrylates, epoxy resins, phenol resins, and polyvinyl alcohols are also effective. Also, the gate insulating film surface may be hydrophobically treated with OTS (octadecyltrichlorosilane), HMDS (hexamethyldisilazane), or the like.

Furthermore, although a fluorine photosensitive resin was used as the bank material in the embodiment described above, the material is not limited to being organic or inorganic as long as it is highly insulating. Also, although the bank height was 3 µm in the embodiment described above, it is no limited thereto, and any height is fine as long as the liquid drops impacting inside the opening of the bank do not come over, exceeding the height.

Furthermore, although a photolithography technique using a photosensitive resin was used as the pattern formation process for the bank in the embodiment described above, a dry process using reactive ion etching (RIE), for example, is fine as well. Also, although a water repellent material is preferable for the bank material, the bank surface may be treated for water repellency after the bank is produced.

Furthermore, although P3HT was used as the organic semiconductor material of the organic TFTs in the embodiment described above, it is not limited thereto, and an organic material showing semiconductor characteristics is fine. For example, a polymer material in which the structure of the low molecular compound described above is used in the main chain of a polymer such as a polyethylene chain, a polysiloxane chain, a polyether chain, a polyester chain, a polyamide chain, or a polyimide chain or joined into a pendant form as a side chain; or a carbon-based conjugated polymer such as a composite conjugated polymer having a structure in which constituent units of an aromatic conjugated polymer such as polyparaphenylene, an aliphatic conjugated polymer such as polyacetylene, a heterocyclic conjugated polymer such as a polypynol or polythiophene, a heteroatom-containing conjugate polymer such as a polyaniline or polyphenylene sulfide, or a conjugated polymer such as poly(phenylenevinylene), poly(anilinevinylene), or poly(thiolinevinylene) are alternately joined may be used. Also, a polymer wherein a carbon-based conjugated structure and an oligosilane with a disilanylene carbon-based conjugated polymer structure such as a polysilane, a disilanylene arylene polymer, a (disilanylene)ethenylene polymer, or a (disilanylene)ethynylene polymer are alternately chained may be used. In addition, a polymer chain comprising an inorganic element such as phosphorous or nitrogen is fine; a polymer in which the aromatic-based ligand of a polymer chain is coordinated such as phthalocyanate polysiloxane, a polymer wherein a perylene is annulled with heat treatment such as perylenetetracarboxylic acid, a ladder polymer obtained by heat treating a polyethylene derivative having a cyano group such as polyacrylonitrile, or a composite material in which an organic compound is intercalated in a perovskite may be used. Also, a phthalocyanine derivative; a naphthalocyanine derivative; an azo compound derivative; a perylene derivative; an indigo derivative; a quinacridone derivative; an anthraquinone or other such polycyclic quinone derivative; a cyanine derivative; a fullerene derivative; a nitrogen-containing polycyclic compound derivative such as indole, carbazole, oxazole, isoxazole, thiazole, imidazole, pyrazol, oxadiazole, pyrazoline, thiathiazole, or triazole; a hydrazine derivative; a triphenylamine derivative; a triphenylmethane derivative; stilbene; anthraquinone diphenoquinone or another such quinone compound derivative; a polycyclic aromatic compound derivative such as anthracene, bilene, phenanthrene, or coronene; or the like is fine; and a material soluble in a solvent such as when furnishing a functional group is fine.

Although the organic EL element was described in the embodiment above as a bottom emission type element for externally extracting light via the first display electrode and substrate, it is not limited thereto, and a top emission type element for externally extracting light via the second display electrode is also fine.

Furthermore, although the organic TFT device is used in an organic EL display device in the embodiment described above, it is not limited thereto, and it may be used in a display device capable of active driving such as a liquid crystal display device or an electrophoretic display device.

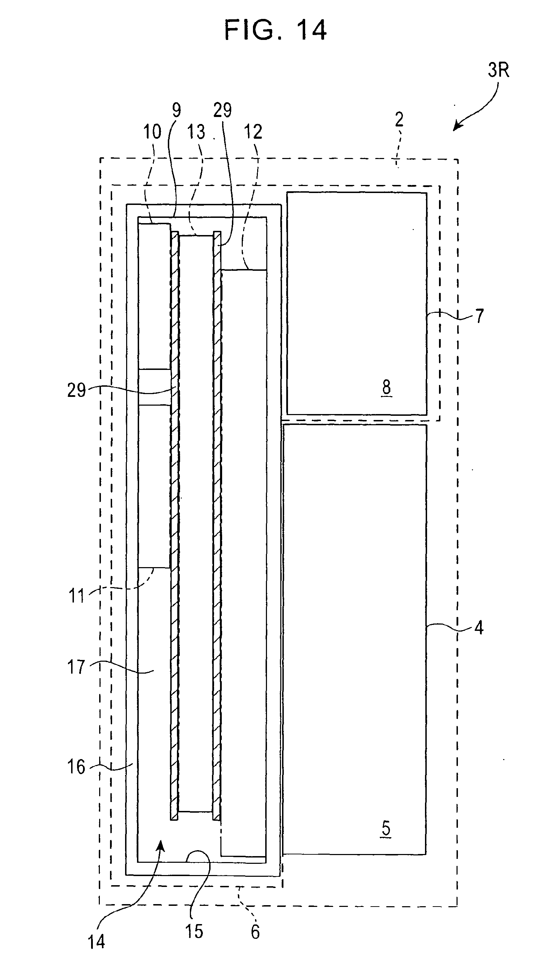

An organic TFT device constituted as shown in Fig. 14 is next explained as an alternate embodiment. Fig. 14 shows a subpixel 3R of an organic EL display device, and the structure of an organic TFT 14 of the alternate embodiment comprises a drive portion 6 of an organic EL element 4. The organic TFT device is provided in a transistor region 9 on a substrate, and a partition 29 is provided between those TFTs of a plurality of organic TFTs 10 to 13 provided in the transistor region 9 which are mutually adjacent. The partition 29 is for preventing a leak current from flowing between the organic TFTs, and does not demarcate the transistor region 9 into a plurality of regions by dividing the region inside an opening 15 of a bank 16. The partition 29 comprises an insulating material similar to the bank 16, a fluorine photosensitive resin, for example. Otherwise, the constitution is nearly the same as the embodiment described above.

The leak current flowing between the mutually adjacent organic TFTs refers to a current flowing between the organic TFTs via an organic semiconductor material present between separate adjacent organic TFTs, and may be generated in response to a variety of factors such as a voltage applied to each organic TFT, the material characteristics of the organic semiconductor layer, or the distance between the organic TFTs. In particular, as the resolution of the display device increases, the interval between the organic TFTs decreases, so there is the danger of a problem occurring. Therefore, a partition is produced between the mutually adjacent TFTs, thereby preventing the leak current from flowing between the organic TFTs.

An organic EL display device was produced having the subpixel 3R with a construction as shown in Fig. 14. The production process is basically nearly the same as the production method of the embodiment described above (refer to Figs. 6 to 13). The size of the subpixel 3R was made 180 µm x 60 µm, and the opening ratio in the organic EL element 4 was made 30%. The channel length of each of the plurality of TFTs 10 to 13 in the transistor region 9 was made 2 µm. The channel width of the first and second organic TFTs 10 to 11 was made 40 µm, and that of the third and fourth organic TFTs 12 and 13 was made 150 µm.
(1) Formation of a gate electrode and a gate insulating film: After forming a Ta thin film on a nonalkaline glass substrate, a Ta thin film pattern was formed using a reactive ion etching process. The pattern Ta thin film was used as the gate electrode. The Ta thin film was anodized, and an oxide film (Ta₂O₅ film) was produced on its surface. The Ta₂O₅ film was used as the gate insulating film. The Ta film thickness was 100 nm, and the Ta₂O₅ film thickness was 150 nm.
(2) Formation of a first display electrode: After producing an IZO film using a magnetron sputter process, a pattern was formed on the IZO film with a lift-off process. The pattern IZO thin film was used as an anode for the organic EL display element. The thickness of the pattern IZO thin film was 110 nm.
(3) Production of a source electrode and drain electrode: After producing a chrome (Cr) thin film and a gold (Au) thin film using a magnetron sputter process, a lift-off process was used to form a pattern in the Cr/Au thin film. Through this process, a mutually separated and opposing source electrode and drain electrode were produced on the gate insulating film. The thickness of the Cr thin film was made 5 nm, and the thickness of the Au thin film was made 100 nm. The distance between mutually adjacent organic TFTs was made 2 µm. That is, the closest distance between electrodes in the combinations of organic TFT source electrodes and drain electrodes of mutually adjacent organic TFTs was 2 µm.
(4) Formation of the bank and partition: After disposing a fluorine photosensitive resin liquid not yet exposed using a spin coat process, a photomask was used for exposure and development, forming the bank and partition. The bank was formed such as to enclose the transistor region and to have one opening, and the partition was formed between positions for forming organic TFTs to be mutually adjacent. The size of the opening of the bank was 20 µm x 170 µm. The width of the partition was 4 µm, and the length was 160 µm. The height of the bank and the partition was 3 µm.
(5) Formation of the organic semiconductor layer: An inkjet process was used to form an organic semiconductor layer in the region surrounded by the bank as described above. Specifically, liquid drops discharged from an ink discharge nozzle were jetted such as to move toward the inside of the opening of the bank, forming the organic semiconductor layer. P3HT was used as the organic semiconductor material to compose the organic semiconductor layer, and a P3HT solution was used as the ink in the inkjet process.
(6) Formation and sealing of an organic EL element: An organic functional layer and a second display electrode were sequentially formed on the first display electrode using vacuum deposition, producing the organic EL element. A dish-shaped sealing cap was used to seal the organic EL element and the organic TFT, making the organic EL display device.

The organic EL display device produced with the procedure described above was driven, and the leak current between the organic TFTs was measured. As a comparative example, an organic EL display device without a partition in the transistor region was also produced. For the comparative organic EL display device, the same procedure was used as above except that the process of forming the bank and partition was changed to one where only the bank was formed without forming the partition. A voltage of 30 V was applied to adjacent electrode intervals for the mutually adjacent organic TFTs in the organic EL display device of both the embodiment and the comparative example.

The current value of the leak current flowing in the mutually adjacent organic TFT intervals was 1.6 × 10⁻¹⁰ A in the embodiment, while that in the comparative example was 5.8 × 10⁻⁷ A. These results confirmed that the leak current is decreased by providing a partition between adjacent organic TFTs.

In both of the embodiments described above, the organic TFTs were described using a bottom gate structure with a gate electrode provided on the substrate, but a top gate structure is fine as well. That is, the organic TFTs may be formed by sequentially producing the source/drain electrodes, the organic semiconductor layer, the gate insulating film, and the gate electrode starting from the substrate. Here, the bank is formed enclosing the transistor region after the source/drain electrodes are produced. The organic semiconductor layer can be produced using an inkjet process and demarcated by the bank similar to the organic TFTs with the bottom gate structure described above.

According to the organic TFT device of the present invention comprising a substrate, and a plurality of organic TFTs disposed in a transistor region on the substrate, wherein the organic TFT device comprises a bank enclosing the transistor region and having a single opening, and a single organic semiconductor layer demarcated by the bank and for forming an organic TFT channel, the organic TFT device can be produced even if the size of each organic TFT and the intervals between the organic TFTs are small because a bank does not need to be provided for each organic TFT when producing the organic TFT device with an inkjet process.

According to the manufacturing method for an organic TFT of the present invention which is for an organic thin film TFT device comprising a substrate, and a plurality of organic TFTs disposed in a transistor region on the substrate, wherein the manufacturing method comprises the steps of forming a plurality of gate electrodes in the transistor region, forming a gate insulating film on each of the gate electrodes, forming a mutually separated and opposing source electrode and drain electrode on each of the gate insulating films, forming a bank enclosing the transistor region and having a single opening, and forming a single organic semiconductor layer as a channel for the organic TFTs using an inkjet process inside the region enclosed by the bank, not only is the production process simplified, but the organic TFTs can be produced using an inkjet process even if the size of each organic TFT and the intervals between the organic TFTs are small because a bank is not required to be provided for each organic TFT.

## Claims

1. An organic thin film transistor device having a substrate and a plurality of organic thin film transistors disposed in a transistor region on said substrate,
said organic thin film transistor device comprising:
a bank enclosing said transistor region and having a single opening; and
a single organic semiconductor layer demarcated by said bank and forming a channel for said organic thin film transistors.

2. The organic thin film transistor device according to claim 1, comprising a partition disposed between said organic thin film transistors which are adjacent.

3. The organic thin film transistor device according to claim 1, wherein said organic semiconductor layer is formed in use of an inkjet process.

4. An organic EL display device comprising the organic thin film transistor device according to any of claims 1 through 3.

5. An electrophoretic display device comprising the organic thin film transistor device according to any one of claims 1 through 3.

6. A liquid crystal display device comprising the organic thin film transistor device according to any one of claims 1 through 3.

7. A manufacturing method for an organic thin film transistor device having a substrate and a plurality of organic thin film transistors disposed in a transistor region on said substrate,
said manufacturing method comprising the steps of:
forming a plurality of gate electrodes in said transistor region;
forming a gate insulating film on each of said gate electrodes;
forming a source electrode and a drain electrode mutually separated and opposing, on each of said gate insulating films;
forming a bank enclosing said transistor region and having a single opening; and
forming a single organic semiconductor layer as a channel for said organic thin film transistors, in use of an inkjet process, inside the region surrounded by said bank.

8. The manufacturing method for an organic thin film transistor device according to claim 7, wherein
said step of forming a bank comprises a step of forming a partition between positions for forming said organic thin film transistors which are mutually adjacent.
